# EUROPEAN PATENT APPLICATION

(11) **EP 2 015 621 A1**
(43) Date of publication of application: **14.01.2009**
(21) Application number: 07714781.7
(22) Date of filing: 22.02.2007
(51) Int. Cl.: H05K 3/12, B41F 17/14, B41F 35/00, B41M 1/10, G02B 5/20, G03G 15/05, G03G 15/10, G09F 9/00

(54) **PLATE, PATTERNING DEVICE EMPLOYING THE PLATE, AND PATTERNING METHOD**

(30) Priority: 14.03.2006 JP 2006069530
(71) Applicant: Kabushiki Kaisha Toshiba, Minato-ku, Tokyo 105-8001 (JP)
(72) Inventor: YAGI, Hitoshi, c/o Intellectual Property Division, Minato-ku, Tokyo 105-8001 (JP); HOSOYA, Masahiro, c/o Intellectual Property Division, Minato-ku, Tokyo 105-8001 (JP); ISHII, Koichi, c/o Intellectual Propety Division, Minato-ku, Tokyo 105-8001 (JP); SAITO, Mitsunaga, c/o Intellectual Property Division, Minato-ku, Tokyo 105-8001 (JP); TAKAHASHI, Ken, c/o Intellectual Property Division, Minato-ku, Tokyo 105-8001 (JP)
(74) Representative: HOFFMANN EITLE
(86) International application number: PCT/JP2007/053283
(87) International publication number: WO 2007/119291

(57) **Abstract**

A pattern forming device has an original plate 1 for pattern formation having pattern-shaped concave portions 15a in a high-resistance layer 15. When phosphor particles collected in the concave portions 15a are transferred to a glass plate M, an electric field is formed between separate electrodes 14r, 14g, and 14b and a transfer roller 3, and a high-frequency voltage is applied to a common electrode 12 to apply a voltage between the separate electrodes 14r, 14g, and 14b, hence to generate ultrasonic waves from a piezoelectric layer 13.

## Description

### Technical Field

The present invention relates to a plate used for manufacturing, for example, a flat typed image display, a wiring substrate, an IC tag and the like, and a pattern forming device and pattern forming method using this plate.

### Background Art

As a technique for forming a fine pattern on the surface of a substrate, conventionally, a photolithography technique has played a central role. The photolithography technique is enhancing the resolution and performance more and more, while it requires huge and expensive manufacturing equipment, hence to increase the manufacturing cost more according to the higher resolution.

In a field of manufacturing an image display as well as a semiconductor device, a request for improvement of performance and price-reduction is increasing and the above photolithography cannot fully cover the request. Under the circumstance, a pattern forming technique using a digital printing technology has been attracting attention.

While, for example, ink jet technology comes into practical use as the patterning technique because of its characteristic of simple structure and non-contact patterning, it is defective in high resolution and high productivity. From this viewpoint, electrophotography, especially, electrophotography using a liquid toner has great potential.

A method of forming a phosphor layer, black matrix, color filter and the like in the front substrate for a flat panel display according to the electrophotography is proposed (for example, refer to Jpn. Pat. Appln. KOKAI Publication Nos. 2004-30980 and 6-265712).

In the field of a flat panel display, a demand for high resolution is more and more increasing and a pattern formation with higher positional precision and higher resolution is required. The above electrophotographic method, however, is difficult to answer the above request. That is because the resolution of a writing optical system is about 1200 dpi, not enough in resolution and alignment. Further, it has yet to realize a writing optical system of wide width compatible with the recent large-sized screen.

On the contrary, there is proposed a method of using an electrostatic printing plate on the surface of which a pattern different in electric resistance is previously formed, instead of a photo conductor, developing the pattern by making a liquid toner act on the plate, and transferring the pattern image to a glass plate, hence to form the pattern of phosphor on the front glass for display (for example, refer to Jpn. Pat. Appln. KOKAI Publication No. 2002-527783).

In order to form a fine pattern image with high resolution on a glass plate by using this method, it is necessary to form a pattern different in electric resistance with high definition, the pattern being previously formed on the electrostatic printing plate, surely transfer the pattern image to a glass plate, and completely clean the unnecessary toner residues in the electrostatic printing plate after the pattern transfer.

### Disclosure of Invention

An object of the invention is to provide a plate on which a fine pattern with high resolution can be formed, and a pattern forming device and pattern forming method using the same plate.

In order to achieve the above object, a plate according to the invention has a holding portion which holds a pattern formed by charged developer, a first electrode to make an electric field act on the pattern held by the holding portion, and an ultrasonic wave generating unit which generates ultrasonic waves to act on the pattern held by the holding portion.

According to the invention, when transferring the pattern formed by the developer held in the holding portion to a medium of transfer destination, an electric field is formed between a supply material which supplies the developer and the first electrode, to urge the pattern in the holding portion from the plate to the medium of transfer destination, and the ultrasonic wave generating unit is operated to generate ultrasonic waves to act on the pattern in the holding portion, hence to remove the pattern from the holding portion of the plate to be transferred to the medium of transfer destination. Thus, the pattern can be surely transferred to the medium of transfer destination.

According to the invention, when cleaning the developer left in the holding portion of the plate after the pattern is transferred, an electric field is formed between the cleaning device and the first electrode of the plate, to urge the developer left in the holding portion toward the cleaning device, and the ultrasonic wave generating unit is operated to generate ultrasonic waves to act on the developer left in the holding portion, hence to remove and eliminate the developer residues from the holding portion of the plate, thereby surely cleaning the developer left in the plate.

Further, a plate according to the invention has a high-resistance layer having open pattern-shaped concave portions on the surface, a first electrode layer provided on a rear surface of the high-resistance layer, a piezoelectric layer provided on a rear surface of the first electrode layer, a second electrode layer provided on a rear surface of the piezoelectric layer, and an ultrasonic wave generating unit which produces an alternating current voltage between the first and second electrode layers to generate ultrasonic waves from the piezoelectric layer.

Further, a pattern forming device according to the invention has: a plate having a holding portion which holds a pattern formed by charged developer, a first electrode to make an electric field act on the pattern held by the holding portion, and an ultrasonic wave generating unit which generates ultrasonic waves to act on the pattern held by the holding portion; a developing device which supplies the charged developer to the holding portion via a supply material arranged opposite to the holding portion and forms an electric field between the supply material and the first electrode to form a pattern by the developer on the holding portion; a transfer device which forms an electric field between a medium of transfer destination arranged facing the holding portion which holds the pattern and the first electrode, to urge the pattern toward the medium of transfer destination, and makes ultrasonic waves act on the pattern through the ultrasonic wave generating unit, hence to remove the pattern from the holding portion to be transferred to the medium of transfer destination; and a cleaning device which cleans the holding portion after the pattern is transferred to the medium of transfer destination.

Further, a pattern forming device according to the invention has: a plate having a high-resistance layer having open pattern-shaped concave portions on the surface, a first electrode layer provided on a rear surface of the high-resistance layer, a piezoelectric layer provided on a rear surface of the first electrode layer, a second electrode layer provided on a rear surface of the piezoelectric layer, and an ultrasonic wave generating unit which produces an alternating current voltage between the first and second electrode layers to generate ultrasonic waves from the piezoelectric layer; a developing device which supplies a liquid developer with charged developer particles dispersed therein to the surface of the high-resistance layer through a supply material arranged opposite to the surface, and forms an electric field between the supply material and the first electrode layer, to collect the developer particles within the liquid developer in the concave portions, thereby developing a pattern; a transfer device which forms an electric field between a medium of transfer destination arranged facing the surface of the high-resistance layer and the first electrode layer, to urge the pattern formed by collecting the developer particles in the concave portions toward the medium of transfer destination, and makes ultrasonic waves act on the pattern through the ultrasonic wave generating unit, to remove the pattern from the concave portions to be transferred to the medium of transfer destination; and a cleaning device which cleans the concave portions after the pattern is transferred to the medium of transfer destination.

A pattern forming method according to the invention has: a developing step of forming a pattern by a developer on a plate comprising an electrode to form an electric field to act on the charged developer and an ultrasonic wave generating unit; and a transfer step of forming an electric field between the electrode and a medium of transfer destination to urge the pattern toward the medium of transfer destination, in a state of making the medium of transfer destination face the plate with the pattern formed by the developer, and operating the ultrasonic wave generating unit to make ultrasonic waves act on the pattern, to remove the pattern from the plate to be transferred to the medium of transfer destination.

### Brief Description of Drawings

FIG. 1 is a schematic view showing a pattern forming device according to an embodiment of the invention.
FIG. 2 is a cross-sectional view of an original plate for pattern formation used in the pattern forming device in FIG. 1.
FIG. 3 is a view for use in describing a wiring structure of a separate electrode of the original plate for pattern formation in FIG. 2.
FIG. 4 is a plane view of the original plate for pattern formation in FIG. 2.
FIG. 5 is a partially enlarged perspective view of the original plate for pattern formation in FIG. 2.
FIG. 6 is a schematic view showing a developing device built in the pattern forming device of FIG. 1.
FIG. 7 is a schematic view for use in describing a transfer process of the pattern forming device in FIG. 1.
FIG. 8 is a schematic view for use in specifically describing the transfer process of the pattern forming device in FIG. 1.
FIG. 9 is a schematic view for use in describing a cleaning process of the pattern forming device in FIG. 1.
FIG. 10 is a schematic view for use in specifically describing the cleaning process of the pattern forming device in FIG. 1.
FIG. 11 is a schematic view showing a pattern forming device according to another embodiment of the invention.

### Best Mode for Carrying Out the Invention

An embodiment of the invention will be hereinafter described in detail with reference to the drawings.

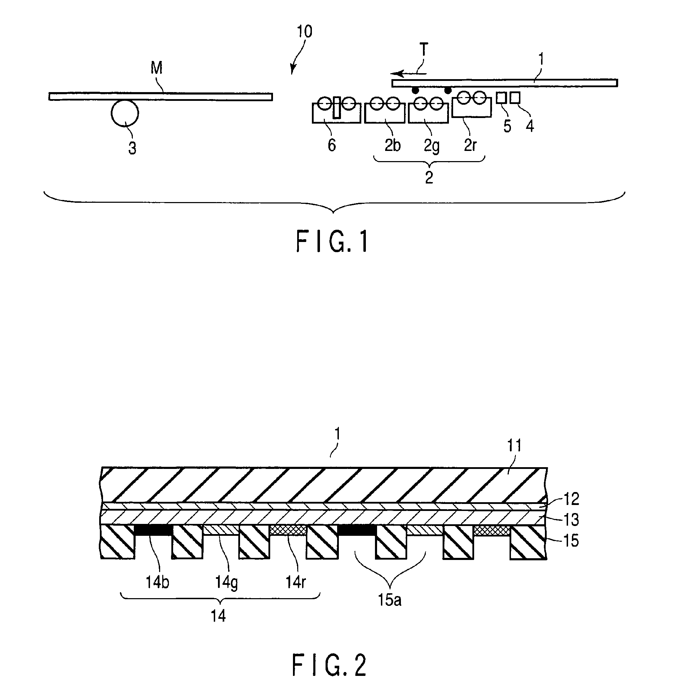

A pattern forming device 10 according to an embodiment of the invention will be described using FIG. 1.

As illustrated in FIG. 1, the pattern forming device 10 has a flat original plate 1 (plate) for pattern formation which is carried in the direction indicated by the arrow T in FIG. 1, a plurality of developing devices 2r, 2g, and 2b (hereinafter, totally referred to a developing device 2 in some cases) arranged under the carrying path of the original plate 1 for pattern formation, which respectively supply the respective color liquid developers (r: red, g: green, b: blue) to the original plate 1 for pattern formation, and a transfer device 3 which transfers the developer particles held in the original plate 1 for pattern formation to a flat medium M of transfer destination waiting in the left of FIG. 1.

The pattern forming device 10 has an alternating current corona ionizer 4 which discharges the surface of a high-resistance layer 15 described later of the original plate 1 for pattern formation, a direct current corona charger 5 which charges the surface of the high-resistance layer 15, for example, at +400 V, and a cleaner 6 (cleaning device) which cleans the original plate 1 for pattern formation after the transfer.

FIG. 2 shows a cross-sectional view of the original plate 1 for pattern formation.

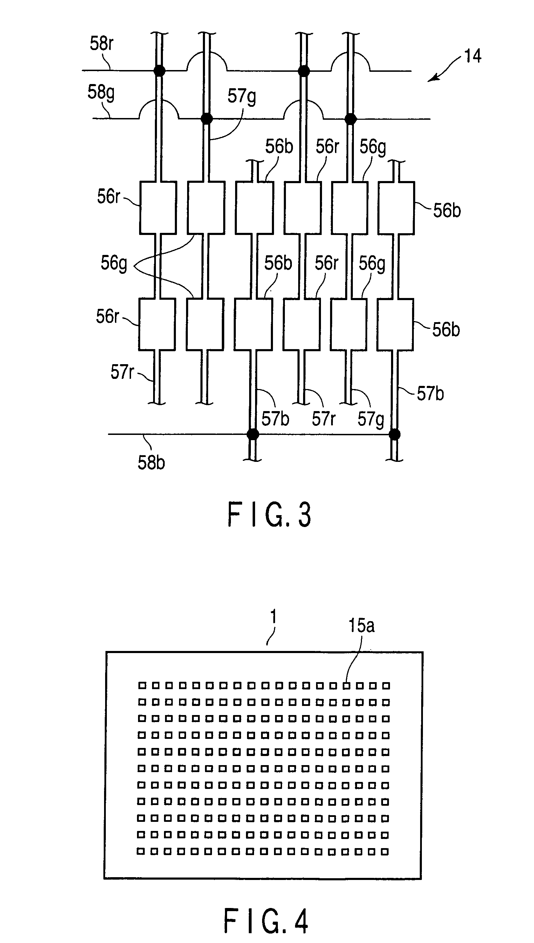

In manufacturing the original plate 1 for pattern formation, a common electrode 12 (second electrode and second electrode layer) formed of a conductive layer such as aluminum is formed on the surface of an insulating material 11 such as a glass plate according to the vapor deposition or sputtering and then a piezoelectric layer 13 is formed. Thereafter, according to the vapor deposition or sputtering, a conductive layer such as aluminum is formed, and then a separate electrode 14 (first electrode and first electrode layer) is formed by patterning the electrode as shown in FIG. 3, according to the photolithography or the like. At last, the original plate 1 for pattern formation is completed by patterning the high-resistance layer 15.

The piezoelectric layer 13 is formed by, for example, PZT-based piezoelectric, lead titanate-based piezoelectric, and piezoelectric with lithium niobate and zinc oxide. The film thickness of this piezoelectric layer 13 is determined by the piezoelectric property and the driving frequency; for example, in the case of the lead titanate-based piezoelectric, when the driving frequency is fixed at 50 MHz, the film thickness becomes about 45 µm. As the method of forming the piezoelectric layer 13, there is a method of bonding a thick film of piezoelectric with adhesive such as epoxy resin and then, polishing it. In the case of using zinc oxide, the piezoelectric layer 13 may be formed according to the sputtering. Further, the piezoelectric material dispersed in solvent may be applied and sintered, hence to form the piezoelectric layer 13.

The separate electrode 14 is patterned such that the respective pixel electrodes 56 of the same color are connected together in every line and the pixel electrodes 56 of different colors are electrically separated from each other, as illustrated in FIG. 3. Namely, a voltage different in each color can be applied to the separate electrode 14 of each color. For example, two red pixel electrodes 56r are connected to a power source for red, not illustrated, through power lines 57r and 58r. Similarly, green pixel electrodes 56g are connected to a power source for green, not illustrated, through power lines 57g and 58g; blue pixel electrodes 56b are connected to a power line for blue, not illustrated, through power lines 57b and 58b. According to this, the pixel electrodes 56 of the respective colors are independently wired, hence to develop a phosphor pattern of three colors using a single intaglio.

The high-resistance layer 15 is formed by a material (including insulator) having volume resistivity of 10¹⁰ Ωcm or more such as polyimide, acrylic, polyester, urethan, epoxy, Teflon (registered trademark), and nylon, into the film thickness of 5 to 50 µm, preferably 10 to 30 µm.

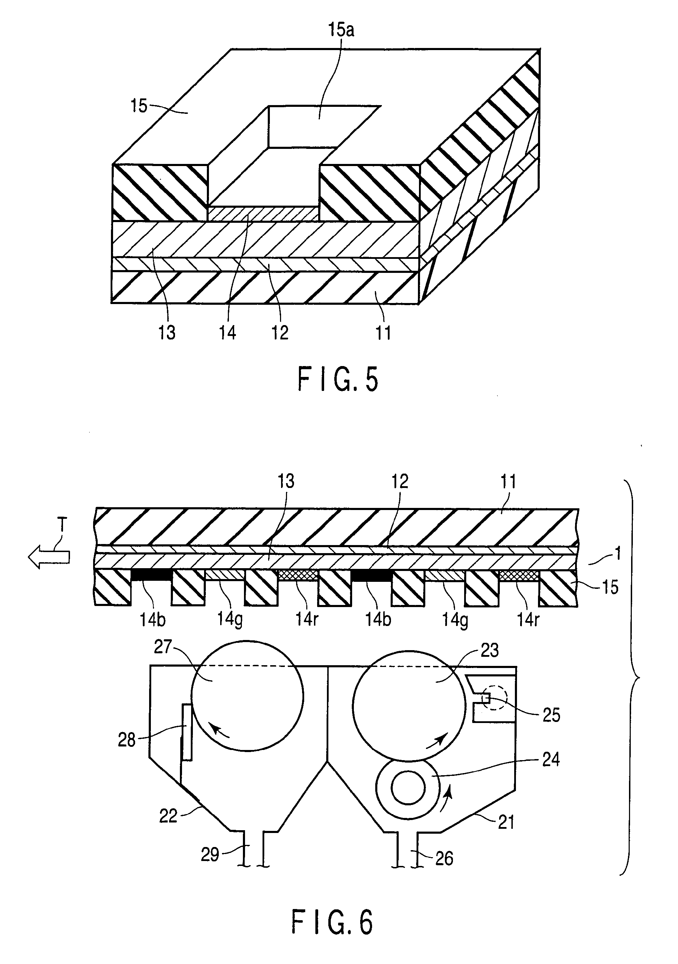

A pattern with many rectangular concave portions 15a (holding portion) disposed is formed on the surface of this high-resistance layer 15, as illustrated in FIG. 4 (plane view). In this embodiment, for example, the concave portions 15a corresponding to the pixels for three colors are recessed from the surface of the high-resistance layer 15, as the original plate 1 for pattern formation which is adopted to manufacture a phosphor screen formed in the front substrate of the flat typed image display. Namely, the concave portions 15a are formed in the positions corresponding to all the pixel electrodes 56r, 56g, and 56b of the separate electrode shown in FIG. 3. As shown by an enlarged cross-sectional view of one concave portion 15a in FIG. 5, the pixel electrode 14 of the separate electrode is bared in the bottom of the concave portion 15a and the depth of the concave portion 15a is roughly equivalent to the thickness of the high-resistance layer 15.

FIG. 6 shows a schematic structure of the developing device 2 in an enlarged way. Since the respective developing devices 2r, 2g, and 2b have the same structure except that the liquid developer to be used is different, the description will be made here as the developing device 2.

The developing device 2 has two cases 21 and 22 aligned along the carrying direction T of the original plate 1 for pattern formation. The original plate 1 for pattern formation is carried with the pattern formed by the above-mentioned concave portions 15a downwardly in a way of facing the developing device 2. A developing roller 23 (supply material) is provided within the case 21 upstream in the carrying direction. The developing roller 23 is arranged so that its peripheral surface may get closer to the surface of the high-resistance layer 15 of the carried original plate 1 for pattern formation with a gap of about 150 ± 50 µm and it rotates in the same direction as the direction of carrying the original plate 1 for pattern formation (counterclockwise in FIG. 6) at a speed of 1.2 times to 4 times, more preferably, 1.5 times to 2.5 times faster.

In the lower portion of the developing roller 23, which is away from the original plate 1 for pattern formation, a sponge roller 24 rotating in the inverse direction to the developing roller 23 is arranged in contact with the roller 23. This sponge roller 24 cleans the liquid developer attached to the peripheral surface of the developing roller 23 passing the original plate 1 for pattern formation at the opposite position. A nozzle 25 for supplying the liquid developer to the peripheral surface of the developing roller 23 is provided in the inner surface of the case 21.

The liquid developer is accommodated in a developer tank (not illustrated) and supplied to the case 21 through the nozzle 25 by a pump (not illustrated), and the liquid developer residues collected by the sponge roller 24 are collected into the developer tank through an exhaust hole 26 provided in the bottom portion of the case 21. The liquid developer is formed by dispersing the charged phosphor particles (developer particles) of each color in the insulating liquid. The phosphor particle of each color has metallic soap added so as to be charged positively.

A squeeze roller 27 is provided within the case 22 downstream in the direction of carrying the original plate 1 for pattern formation. The squeeze roller 27 is arranged so that its peripheral surface may get much closer to the original plate 1 for pattern formation than that of the developing roller 23, namely, in this embodiment, at a distance of 25 to 75 µm, more preferably, 30 to 50 µm from the surface of the high-resistance layer 15, and it rotates in the inverse direction to the direction T of carrying the original plate 1 for pattern formation (clockwise in FIG. 6). The squeeze roller 27 partially deletes the liquid developer supplied in the intaglio plate 1 by the developing roller 23 to control the liquid developer remaining in the intaglio plate 1 to have the film thickness of about 1 to 30 µm.

A cleaning blade 28 made of rubber piece is arranged in contact with the peripheral surface of the squeeze roller 27. The liquid developer residues collected from the peripheral surface of the squeeze roller 27 by the cleaning blade 28 are collected into a developer tank (not illustrated) through an exhaust hole 29 provided in the bottom of the case 22.

The operation of the above-mentioned pattern forming device 10 will be described. The description will be made, for example, in the case where a phosphor layer of each color is formed in the inner surface of the front substrate of the flat typed image display.

First, the original plate 1 for pattern formation is carried in the direction of the arrow T at a constant speed, as illustrated in FIG. 1. At this time, the alternating current corona ionizer 4 applies an alternating current high voltage to a corona wire (not illustrated), to discharge the surface of the high-resistance layer 15 in the original plate 1 for pattern formation. Just after that, the direct current corona charger 5 applies a positive high voltage to the corona wire, to generate a positive corona and charge the surface of the high-resistance layer 15 in the original plate 1 for pattern formation, for example, at +400 V.

The developing device 2r which develops the first red color is arranged in the operating position (the position shown in FIG. 1). Then, the developing device 2r supplies the liquid developer including the red phosphor particle to the surface of the high-resistance layer 15 in the original plate 1 for pattern formation. At this time, the liquid developer is carried by the peripheral surface of the developing roller 23 rotating counterclockwise in FIG. 6 as a liquid film with a thickness of about several hundred micrometers and this liquid film is directly supplied to the surface of the high-resistance layer 15 in the intaglio plate 1. The liquid developer is also supplied into the concave portions 15a of the pattern formed on the surface of the high-resistance layer 15.

At this time, a power source (not illustrated) applies a voltage of +200 V to the developing roller 23. Simultaneously, the red separate electrode 14r in the original plate 1 for pattern formation is grounded and it applies a voltage of +300 V between the green separate electrode 14g and the blue separate electrode 14b. The red phosphor particle positively charged within the liquid developer intervening between the developing roller 23 and the original plate 1 for pattern formation in contact with each other is repelled by the surface of the high-resistance layer 15 charged at +400 V and the green and blue separate electrodes 14g and 14b with +300 V voltage applied, while it is attracted to the grounded red separate electrode 14r because of a function of the potential difference of 200 V. Namely, owing to the function of the both, the red phosphor particles are collected into the red separate electrode 14r. When the development by the red developer is completed, the peripheral surface of the developing roller 23 is cleaned by the sponge roller 24 and the liquid developer which is not supplied to the original plate 1 for pattern formation is collected by the tank (not illustrated) through the exhaust hole 26.

Just after the above development of the red developer, the liquid film with a thickness of about 100 µm is attached to the surface of the high-resistance layer 15 in the original plate 1 for pattern formation, and the phosphor particles which are not gathered in the concave portions 15a of the red pattern are floating inside the liquid film. Floating of these phosphor particles causes fog, and therefore, the liquid film has to be squeezed by the squeeze roller 27 and the floating phosphor particles have to be bonded to the surface of the squeeze roller 27 and collected.

At this time, a voltage of about 200 ± 50 V is applied to the squeeze roller 27 through a power supply (not illustrated), and according to the voltage, the phosphor particles floating in the liquid film are attracted by the squeeze roller 27. At this point, the liquid film with a thickness of about 1 to 30 µm remains on the surface of the high-resistance layer 15 in the original plate 1 for pattern formation after passing through the squeeze process by the squeeze roller 27. In other words, the removing amount of the liquid film by the squeeze roller 27 is controlled in order to leave the liquid film with this thickness on the surface of the original plate 1 for pattern formation. Namely, the intaglio 1 remains wet after the development of the first color.

The above operation is sequentially and similarly performed in the developing device 2g which executes the development of the second green color and in the developing device 2b which executes the development of the third blue color, hence to form a pattern of three phosphor particles on the original plate 1 for pattern formation.

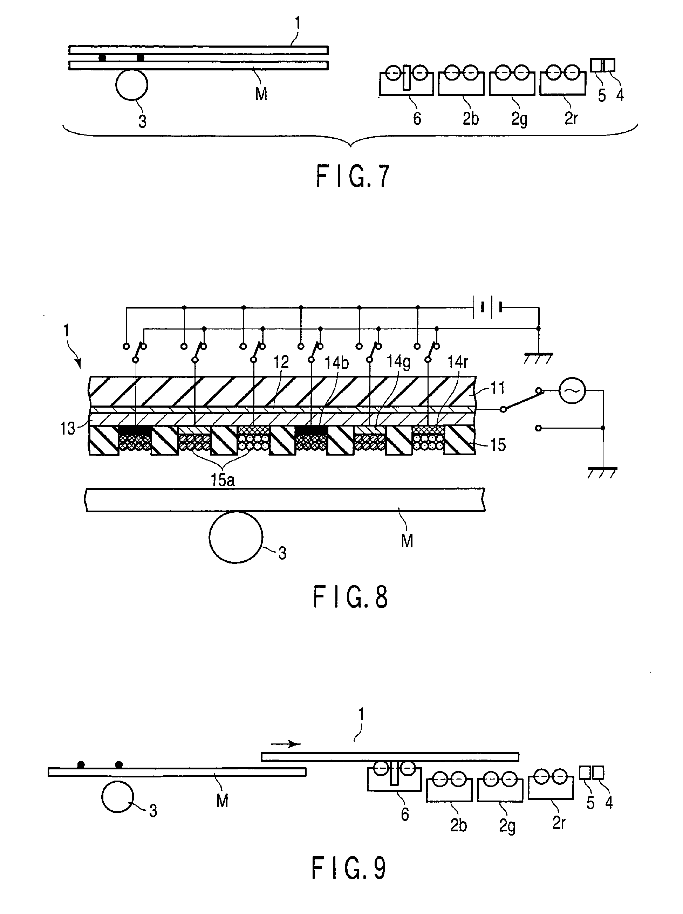

Then, the original plate 1 for pattern formation is carried to the transfer process. As illustrated in FIG. 7, the original plate 1 with the pattern of three color phosphor particles formed thereon is arranged above and away from a glass plate M which is on standby downstream in the carrying direction. In this state, the original plate 1 for pattern formation stays above the glass plate M at such a distance that the glass plate M does not come into contact with the liquid developer wet on the surface of the high-resistance layer 15 of the original plate 1 for pattern formation. Here, the original plate 1 for pattern formation is aligned with the glass plate M, by an alignment mechanism not illustrated. The alignment mechanism reads out the alignment marks previously marked on both the original plate 1 for pattern formation and the glass plate M, using optical means, detects some deviation between the both, and moves the original plate 1 for pattern formation and the glass plate M relatively in order to correct the deviation.

As mentioned above, after the original plate 1 for pattern formation and the glass plate M are aligned at high precision, the insulating liquid humidifying the surface of the original plate 1 for pattern formation is made into contact with the surface of the glass plate M, to apply a negative high voltage there through a transfer device 3 which is arranged in contact with the back surface (the bottom surface in FIG. 7) of the glass plate M spaced from the original plate 1 for pattern formation and to apply a high-frequency voltage to the common electrode 12 of the original plate 1 for pattern formation to irradiate ultrasonic waves from the piezoelectric layer 13, thereby transferring the phosphor particles to the glass substrate M.

At this time, the above operation of transferring the pattern will be specifically described using FIG. 8. A negative high voltage of, for example, about -7 kV is applied to the transfer device 3 formed by a conductive elastic roller which is arranged and pressed to the back surface of the glass plate M, through a power source not illustrated, while the separate electrodes 14 are all grounded. Then, a potential difference is generated between the glass plate M and the separate electrode 14 of the original plate 1 for pattern formation, and an electric field toward the glass plate M is generated around the positively charged phosphor particles gathered in the concave portions 15a of the original plate 1 for pattern formation.

At this time, a sine wave high frequency of about ±50 V (driving frequency of 50 MHz) is simultaneously applied to the common electrode 12 and ultrasonic waves are irradiated from the piezoelectric layer 13. The ultrasonic waves act on the phosphor particles collected in the concave portions 15a, with the result that the phosphor particles are removed from the concave portions 15a. Thus, it is found that according to the transfer method using both the electric field function and the ultrasonic wave function, the thick film developed in the concave portions and the large-grain phosphor particles can be transferred to the glass substrate M efficiently.

The original plate 1 for pattern formation after the transfer process is completed is carried to the cleaning process, as illustrated in FIG. 9. As mentioned above, although the transfer efficiency can be improved according to the electric field function and the ultrasonic wave function, there is a possibility of few phosphor particles still remaining in the concave portions 15a of the original plate 1 for pattern formation. Therefore, the phosphor particle residues in the concave portions 15a have to be cleaned.

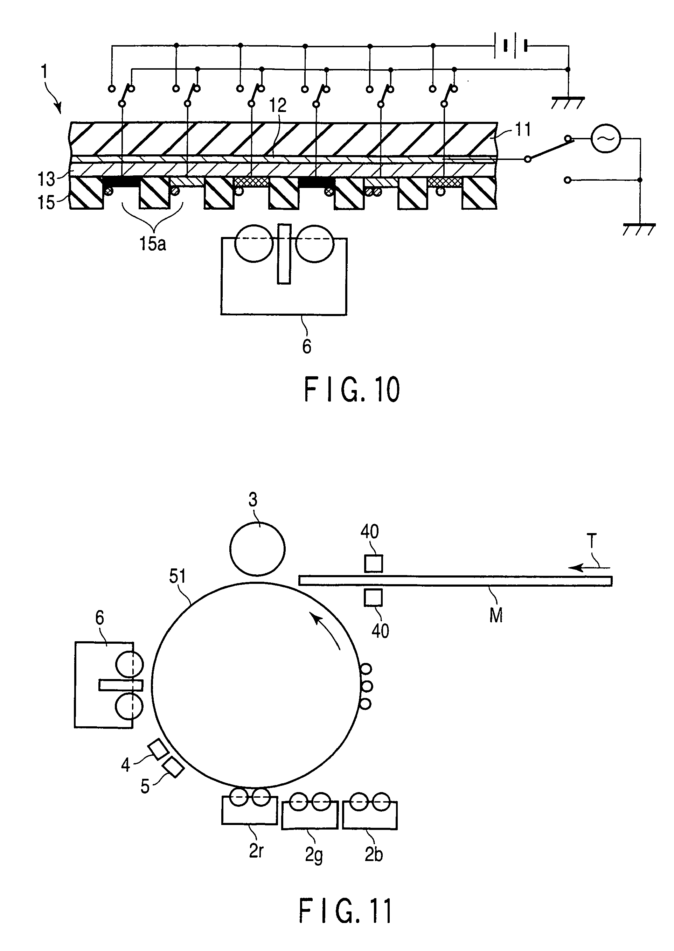

As illustrated in FIG. 9, a cleaner 6 is raised up to the operational position, by an elevating mechanism (not illustrated) and the liquid developer residues in the original plate 1 for pattern formation are cleaned. As illustrated in FIG. 10, simultaneously with the cleaning operation by the cleaner 6, a sine wave high frequency of ±50 V (driving frequency of 50 MHz) is applied to the common electrode 12 of the original plate 1 for pattern formation, and the ultrasonic waves are irradiated from the piezoelectric layer 13 similarly to the above transfer process. Thus, by irradiating the ultrasonic waves at the time of operating the cleaner 6, the cleaning efficiency can be remarkably improved.

The cleaner 6 cleans the phosphor particle residues by applying a voltage of about -300 V to the cleaning rollers to form an electric field between the separate electrode 14 and themselves, making the electric field act on the phosphor particle residues in the concave portions 15a, and making the cleaning rollers adsorb the phosphor particles. At this time, for example, when the phosphor particle residues are attached to the corners of the concave portions 15a, the ultrasonic waves act on the phosphor particles, hence to surely eliminate them.

As mentioned above, according to this embodiment, by using both the electric field function and the ultrasonic wave function at the transfer of the phosphor particles, the thick film and the large-grain phosphor particles collected in the concave portions 15a of the original plate 1 for pattern formation can be efficiently and surely transferred to the glass plate M. Further, by the action of the electric field and the action of the ultrasonic waves in the cleaning operation mode, cleaning efficiency can be remarkably improved.

Namely, by using the original plate 1 for pattern formation of this embodiment, almost all the phosphor particles collected in the concave portions 15a can be transferred to the glass plate M, and it is possible to prevent disturbance of image caused by failure of transfer, hence to form a good transfer image. By using the original plate 1 for pattern formation in this embodiment, it is possible to surely clean some phosphor particles that can remain in the concave portions 15a, to always provide a clean original plate 1, and to form a fine pattern with high resolution.

Although the case of patterning using the flat original plate 1 for pattern formation has been described in the above-mentioned embodiment, the invention is not restricted to this but as illustrated in FIG. 11, a drum-shaped original plate 51 can be used by winding the above-mentioned original plate 1 for pattern formation around the peripheral surface of a cylinder and directly forming an original plate for pattern formation on the peripheral surface of a cylinder.

When forming a phosphor pattern of three colors on the glass plate M using this original plate 51, at first, the peripheral surface of the original plate 51 is electrically discharged by the alternating current corona ionizer 4, and the surface of the high-resistance layer 15 of the original plate 51 is positively charged by the direct current corona charger 5. Then, the developing device 2r gathers the red phosphor particles in the concave portions 15a of the original plate 51, hence to develop a red pattern. The charging/developing process is the same as the above mentioned embodiment. Similarly, the developing device 2g develops the green phosphor particles, and the developing device 2b develops the blue phosphor particles.

The glass plate M is carried from the right to the left in FIG. 11, by a carrying device not illustrated, proceeding between the transfer roller 3 and the original plate 51. The transfer roller 3 is formed by a conductive rubber roller, for example, with rubber hardness of 40 degrees, and a voltage of -7 kV is applied there through a power source not illustrated. At this time, a voltage is applied to the piezoelectric layer 13 of the original plate 51, to emit the ultrasonic waves, which act on the phosphor particles of the respective colors in the concave portions 15a. Under this condition, a phosphor layer of three colors is transferred to the glass plate M. In the transfer, the alignment marks respectively marked in the glass plate M and the original plate 51 are detected by an alignment mechanism not illustrated, and transfer is performed while controlling the relative movement of the both at high accuracy.

Thereafter, the surface of the high-resistance layer 15 of the original plate 51 is cleaned by the cleaner 6. Also at the cleaning time, ultrasonic waves as well as an electric field act on the phosphor particles as mentioned above, hence to surely clean the phosphor particle residues in the concave portions 15a.

The original plate 51 is electrically discharged and charged in order to develop and transfer the phosphor layer to another medium. The glass plate M is carried by a carrying device 31 in the inverse direction, back to the initial position, where unnecessary charge residues are eliminated by a charge eliminating device 40.

As mentioned above, when using the drum-shaped original plate 51, a system can be downsized compared with the above-mentioned original plate 1 for pattern formation, thereby saving the space. By forming the original plate 51 in cylindrical shape, the original plate 51 can be gradually brought into/out of contact with the flat glass plate M, hence to prevent disturbance occurring in the liquid film intervening between the both and prevent such a defect that the phosphor layer transferred to the glass plate M is removed.

The invention is not restricted to the above-mentioned embodiment itself, but various modifications can be made in the practical stage with some components modified without departing from the effect. Various inventions can be formed by a proper combination of several components disclosed in the above-mentioned mode. For example, some components may be deleted from all the components described in the above embodiment. Further, a proper combination of the components concerned with different embodiments may be used.

For example, although the structure of interposing the piezoelectric layer 13 between the common electrode 12 and the separate electrode 14 as an ultrasonic wave generating unit is adopted in the above-mentioned mode, the invention is not restricted to this but another ultrasonic wave generating means may be used. For example, the ultrasonic wave generating means may be formed externally in the back surface of the substrate of the original plate for pattern formation.

Although the case where the separate electrodes 14 of the original plate 1 for pattern formation are formed electrically separately in every color has been described in the above-mentioned embodiment, the invention is not restricted to this, but the number of the concave portions 15a is reduced to one-third as the plate for one color and a so-called solid-like electrode layer may be formed at the position of the separate electrodes 14. In this case, the phosphor particles may be developed for every one color and transferred to the glass plate M.

Although the case of operating the pattern forming device with the phosphor particles charged positively has been described in the above-mentioned embodiment, the invention is not restricted to this but all the components may be operated being inversely charged.

Further, although the case of applying the invention to the device of forming a phosphor layer or a color filter on the front substrate in the flat typed image display has been described in the above-mentioned embodiment, the invention may be widely used as a manufacturing device in other technical fields.

For example, when the composition of the liquid developer is changed, the invention can be applied to a device for forming a conductive pattern in a circuit substrate or an IC tag. In this case, when the liquid developer is formed by, for example, resin particles with average particle size of 0.3 µm, metallic microparticles with average particle size of 0.02 µm attached to their surfaces (for example, copper, palladium, silver, platinum and the like), and a charge controlling agent such as metallic soap, it is possible to form a wiring pattern, for example, on a silicon wafer using the developer, according to the same method as the above-mentioned embodiment. Generally, since only the use of this developer cannot easily form a circuit pattern having a good conductivity, it is preferable that it is plated with the above metallic microparticles as nuclei after the pattern formation. According to this, it is possible to pattern a conductive circuit, a condenser, and a resistor.

### Industrial Applicability

Since the plate of the invention and the pattern forming device have the above configuration and the functions, a pattern can be surely transferred to a medium of transfer destination by the developer, and the developer residues in the plate after the transfer can be surely cleaned, thereby forming a fine pattern with high resolution.

## Claims

1. A plate **characterized by** comprising:
a holding portion which holds a pattern formed by charged developer;
a first electrode to make an electric field act on the pattern held by the holding portion; and
an ultrasonic wave generating unit which generates ultrasonic waves to act on the pattern held by the holding portion.

2. The plate according to claim 1, **characterized in that** the holding portion has pattern-shaped concave portions capable of accommodating the developer.

3. The plate according to claim 2, **characterized in that** the first electrode is provided in a bottom of the concave portion.

4. The plate according to claim 3, **characterized in that** the ultrasonic wave generating unit has a piezoelectric provided on a rear surface of the first electrode and a second electrode to operate the piezoelectric in cooperation with the first electrode.

5. The plate according to claim 1, which is provided on a peripheral surface of a cylinder.

6. A plate **characterized by** comprising:
a high-resistance layer having open pattern-shaped concave portions on the surface;
a first electrode layer provided on a rear surface of the high-resistance layer;
a piezoelectric layer provided on a rear surface of the first electrode layer;
a second electrode layer provided on a rear surface of the piezoelectric layer; and
an ultrasonic wave generating unit which produces an alternating current voltage between the first and second electrode layers to generate ultrasonic waves from the piezoelectric layer.

7. A pattern forming device **characterized by** comprising:
a plate having a holding portion which holds a pattern formed by charged developer, a first electrode to make an electric field act on the pattern held by the holding portion, and an ultrasonic wave generating unit which generates ultrasonic waves to act on the pattern held by the holding portion;
a developing device which supplies the charged developer to the holding portion via a supply material arranged opposite to the holding portion and forms an electric field between the supply material and the first electrode to form a pattern by the developer on the holding portion;
a transfer device which forms an electric field between a medium of transfer destination arranged facing the holding portion which holds the pattern and the first electrode, to urge the pattern toward the medium of transfer destination, and makes ultrasonic waves act on the pattern through the ultrasonic wave generating unit, hence to remove the pattern from the holding portion to be transferred to the medium of transfer destination; and
a cleaning device which cleans the holding portion after the pattern is transferred to the medium of transfer destination.

8. The pattern forming device according to claim 7, **characterized in that** the cleaning device forms an electric field between the first electrode and itself to attract the developer left in the holding portion and urges the ultrasonic wave generating unit to make the ultrasonic waves act on the developer residues in order to remove the developer residues from the holding portion.

9. The pattern forming device according to claim 7 or 8, **characterized in that** the holding portion has pattern-shaped concave portions capable of accommodating the developer.

10. The pattern forming device according to claim 9, **characterized in that** the first electrode is provided in a bottom of the concave portion.

11. The pattern forming device according to claim 10, **characterized in that** the ultrasonic wave generating unit has a piezoelectric provided on a rear surface of the first electrode and a second electrode to operate the piezoelectric in cooperation with the first electrode.

12. The pattern forming device according to claim 7, **characterized in that** the plate is provided on a peripheral surface of a cylinder.

13. A pattern forming device **characterized by** comprising:
a plate having a high-resistance layer having open pattern-shaped concave portions on the surface, a first electrode layer provided on a rear surface of the high-resistance layer, a piezoelectric layer provided on a rear surface of the first electrode layer, a second electrode layer provided on a rear surface of the piezoelectric layer, and an ultrasonic wave generating unit which produces an alternating current voltage between the first and second electrode layers to generate ultrasonic waves from the piezoelectric layer;
a developing device which supplies a liquid developer with charged developer particles dispersed therein to the surface of the high-resistance layer through a supply material arranged opposite to the surface, and forms an electric field between the supply material and the first electrode layer, to collect the developer particles within the liquid developer in the concave portions, thereby developing a pattern;
a transfer device which forms an electric field between a medium of transfer destination arranged facing the surface of the high-resistance layer and the first electrode layer, to urge the pattern formed by collecting the developer particles in the concave portions toward the medium of transfer destination, and makes ultrasonic waves act on the pattern through the ultrasonic wave generating unit, to remove the pattern from the concave portions to be transferred to the medium of transfer destination; and
a cleaning device which cleans the concave portions after the pattern is transferred to the medium of transfer destination.

14. The pattern forming device according to claim 13, **characterized in that** the cleaning device forms an electric field between the first electrode layer and itself to attract the developer particles left in the concave portions and urges the ultrasonic wave generating unit to make the ultrasonic waves act on the developer residues in order to remove the developer residues from the holding portion.

15. The pattern forming device according to claim 13, **characterized in that** the first electrode layer is provided in a bottom of the concave portion.

16. The pattern forming device according to claim 13, **characterized in that** the plate is provided on a peripheral surface of a cylinder.

17. A pattern forming method **characterized by** comprising:
a developing step of forming a pattern by a developer on a plate comprising an electrode to form an electric field to act on the charged developer and an ultrasonic wave generating unit; and
a transfer step of forming an electric field between the electrode and a medium of transfer destination to urge the pattern toward the medium of transfer destination, in a state of making the medium of transfer destination face the plate with the pattern formed by the developer, and operating the ultrasonic wave generating unit to make ultrasonic waves act on the pattern, to remove the pattern from the plate to be transferred to the medium of transfer destination.

18. The pattern forming method according to claim 17, **characterized by** further comprising:
a cleaning step of urging a developer left in a plate having the pattern transferred after forming an electric field between the electrode and a cleaning device, toward a direction away from the plate and operating the ultrasonic wave generating unit to make ultrasonic waves act on the developer residues to remove the same from the plate, thereby cleaning the developer residues.
